(19) Europäisches Patentamt
European Patent Office
Office européen des brevets

(11) EP 2 707 952 B1

(12) FASCICULE DE BREVET EUROPEEN

(45) Date de publication et mention
de la délivrance du brevet:
**10.10.2018 Bulletin 2018/41**

(21) Numéro de dépôt: **12714020.0**

(22) Date de dépôt: **17.04.2012**

(51) Int Cl.:
***H03G 3/30*** (2006.01)

(86) Numéro de dépôt international:
**PCT/EP2012/056999**

(87) Numéro de publication internationale:
**WO 2012/152549 (15.11.2012 Gazette 2012/46)**

(54) **CIRCUIT DE CORRECTION AUTOMATIQUE DE GAIN À CONSIGNE VARIABLE**

SCHALTUNG ZUR AUTOMATISCHEN KORREKTUR EINER VERSTÄRKUNG MIT VARIABLEM SOLLWERT

AUTOMATIC GAIN CONTROL CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.05.2011 FR 1101442**

(43) Date de publication de la demande:
**19.03.2014 Bulletin 2014/12**

(73) Titulaire: **THALES**
**92400 Courbevoie (FR)**

(72) Inventeurs:
• **PERRE, Jean-Michel**
**F-07130 Saint Peray (FR)**
• **DEPRAZ, David**
**F-26000 Valence (FR)**
• **BERTHOZ, Fréderic**
**F-26000 Valence (FR)**

(74) Mandataire: **Derval, Estelle et al**
**Marks & Clerk France**
**Conseils en Propriete Industrielle**
**Immeuble Visium**
**22, avenue Aristide Briand**
**94117 Arcueil Cedex (FR)**

(56) Documents cités:
**US-A- 4 191 995        US-A- 4 910 797**
**US-A1- 2004 092 238**

## Description

L'invention concerne un circuit de correction automatique de gain pour des signaux radiofréquence. Elle s'applique notamment à la régulation de l'amplification de signaux pour la radionavigation par satellite.

La radionavigation par satellite utilise certaines propriétés de propagation des ondes radioélectriques pour déterminer une position et une vitesse d'un mobile à partir de signaux émis depuis des satellites. Les durées de propagation des ondes radioélectriques émises par les satellites permettent de déterminer des pseudo-distances entre le mobile et les satellites. Par une résolution voisine de la triangulation, il est possible de déduire la position du mobile. Les signaux émis par les satellites étant peu puissants, ils sont facilement brouillés. Le brouillage constitue l'une des principales menaces sur la disponibilité et la continuité du service de radionavigation par satellite. De nombreuses solutions d'antibrouillage existent ou sont en cours de développement. Dans la majorité de ces solutions, le système d'antibrouillage mis en oeuvre comporte une chaîne radiofréquence de sélection, d'amplification et de numérisation du signal sur une bande de fréquences. Le signal est notamment quantifié en amplitude sur une échelle donnée et avec une précision donnée. L'utilisation optimale de l'échelle de quantification dépend naturellement de la puissance du signal reçu et du gain d'amplification du signal. En conséquence, le gain d'amplification est généralement régulé en fonction de la puissance du signal reçu par un circuit dit de correction automatique de gain.

La puissance du signal utile, c'est-à-dire du signal provenant d'un satellite, se situe environ 30 dB en dessous du bruit thermique, alors que la puissance des signaux de brouillage ou d'interférence est en général largement supérieure à la puissance du bruit thermique. En l'absence de signaux de brouillage, l'amplification des signaux est ajustée pour une quantification optimale du bruit thermique. Une quantification sur un faible nombre de bits, par exemple entre un et trois, peut suffire pour démoduler le signal et l'exploiter. En revanche, en présence de signaux de brouillage, l'amplification des signaux est ajustée pour une quantification optimale des signaux de brouillage, ce qui conduit à perdre l'information de signal utile et de bruit thermique si la quantification est réalisée sur un faible nombre de bits. Afin de pouvoir quantifier le signal utile et le bruit thermique, la quantification doit donc être réalisée sur un nombre suffisant de bits, de l'ordre de 6 ou 7 bits minimum. Un problème se pose néanmoins quant au niveau de la consigne de régulation à appliquer. Si le niveau de consigne est proche du bas de l'échelle du quantifieur, les signaux de brouillage de courte durée (n'affectant pas la régulation) sont quantifiés sur toute l'échelle et peuvent donc être supprimés par un traitement mathématique linéaire. En revanche, les signaux de brouillage continus (pris en compte dans la régulation) sont quantifiés uniquement autour des valeurs basses de l'échelle. Il est alors difficile de les caractériser et de les filtrer. En outre, le signal utile risque d'être perdu. A l'inverse, si le niveau de consigne est proche du haut de l'échelle, le signal utile et les signaux de brouillage continus sont correctement quantifiés. Cependant, les signaux de brouillage de courte durée sont saturés et donc mal traités. De plus, en l'absence de brouillage, le gain en amplification est continuellement très élevé puisqu'il doit remonter en haut de l'échelle de quantification le niveau de bruit thermique, qui est de l'ordre de - 100 dBm en entrée de l'antenne du système de radionavigation. Le gain en amplification peut ainsi atteindre 100 dB. Une telle amplification est d'autant plus difficile à réaliser que la chaîne radiofréquence a en général un petit facteur de forme et utilise une unique transposition de fréquence. Un compromis est d'appliquer un niveau de consigne au milieu de l'échelle. Cependant, un tel niveau de consigne ne permet pas de quantifier de manière optimale le signal utile, les signaux de brouillage de courte durée, et les signaux de brouillage continus.

La demande de brevet US2004/092238 A1 se rapporte à un récepteur sans fil comprenant une unité de sélection de gain contrôlant divers éléments, et notamment le gain d'un amplificateur. Le gain est sélectionné de façon discrète.

Un but de l'invention est notamment de remédier à tout ou partie des inconvénients précités en permettant une adaptation du gain d'amplification en fonction de la puissance du signal reçu.

A cet effet, l'invention a pour objet un circuit de correction automatique de gain selon l'une quelconque des revendications.

L'invention a notamment pour avantage d'amplifier le signal d'entrée en fonction de la présence de signaux de brouillage et de leur type, et donc de permettre une quantification adaptée du signal utile et, le cas échéant, des signaux de brouillage.

L'invention sera mieux comprise et d'autres avantages apparaîtront à la lecture de la description qui va suivre, faite en regard de dessins annexés sur lesquels :

- la figure 1 illustre un exemple d'amplification d'un signal reçu par une chaîne radiofréquence de l'état de la technique ;
- la figure 2 illustre le principe à la base d'un circuit de correction automatique de gain selon l'invention ;
- la figure 3 représente un circuit de correction automatique de gain selon l'état de la technique ;
- les figures 4 et 5 illustrent le fonctionnement du circuit de correction automatique de gain de la figure 3 par des amplitudes d'un signal interne et d'un signal en sortie de ce circuit ;
- la figure 6 représente un exemple de circuit de correction automatique de gain selon l'invention ;
- les figures 7 et 8 illustrent le fonctionnement du circuit de correction automatique de gain de la figure 6 par les amplitudes des signaux des figures 4 et 5 correspondants ;

- la figure 9 représente l'amplitude du signal en sortie du circuit de correction automatique de gain de la figure 6 pour un signal en entrée de ce circuit à cinq paliers de puissance ;
- la figure 10 représente, par un graphique, un exemple de relation entre la puissance du signal en entrée du circuit de correction automatique de gain de la figure 6 et une consigne déterminée par ledit circuit ;
- la figure 11 représente, par un graphique analogue à celui de la figure 10, des exemples de relation entre la puissance du signal en entrée du circuit de correction automatique de gain de la figure 6 et la consigne déterminée par ledit circuit en présence de préamplificateurs dont les gains diffèrent ;
- la figure 12 représente un exemple de circuit de réception intégrant le circuit de correction automatique de gain de la figure 6.

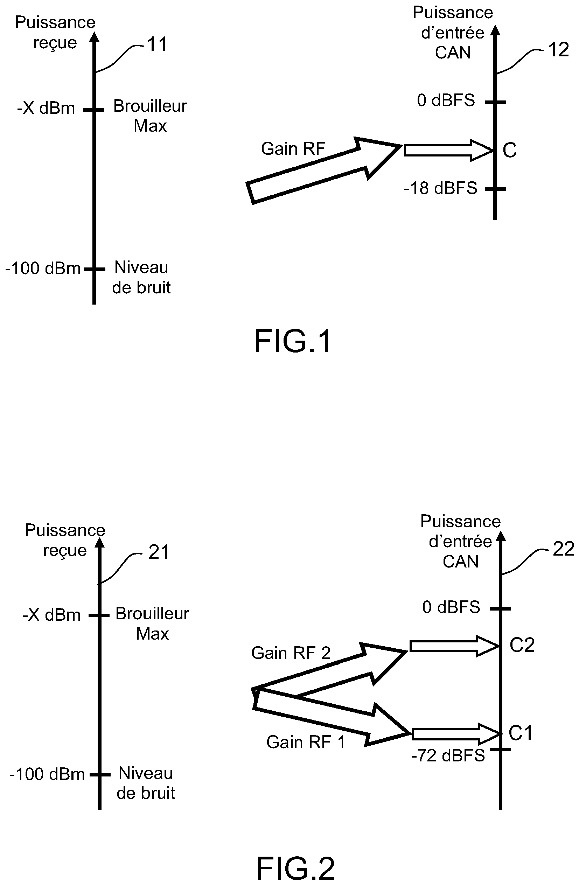

La figure 1 illustre un exemple d'amplification d'un signal reçu par une chaîne radiofréquence (RF) en vue d'une numérisation. A titre d'exemple, on considère le cas d'un signal RF utilisé pour la radionavigation par satellite. L'amplification du signal reçu est asservie en puissance par un circuit dit de correction automatique de gain, implanté dans la chaîne RF. Les puissances considérées sont donc des puissances moyennes sur une durée de quelques millièmes à quelques dixièmes de seconde, en fonction du temps de réponse de la boucle d'asservissement du circuit de correction automatique de gain. Un premier axe vertical 11 représente une plage de puissance du signal reçu par la chaîne RF, en dBm. Le signal reçu par la chaîne RF a une puissance susceptible de varier entre une puissance minimale et une puissance maximale. Un signal émis par un satellite a une puissance relativement faible, généralement inférieure à la puissance du bruit thermique de la chaîne RF. Par ailleurs, la chaîne RF peut recevoir des signaux de forte puissance provenant d'autres sources, qui viennent brouiller le signal du satellite. Ainsi, la puissance du signal reçu par la chaîne RF peut varier entre une valeur minimale, par exemple - 100 dBm, correspondant à la puissance du bruit thermique, et une valeur maximale, notée - X dBm, correspondant à la puissance d'un signal de brouillage. Le signal amplifié est injecté en entrée d'un convertisseur analogique - numérique (CAN). Un tel convertisseur fonctionne de manière linéaire sur une plage de fonctionnement limitée, appelée échelle de quantification. Autrement dit, la valeur numérique du signal en sortie du convertisseur n'est proportionnelle à l'amplitude du signal en entrée que pour un signal d'entrée dont l'amplitude se situe dans l'échelle de quantification. Cette échelle de quantification est représentée sur la figure 1 par un deuxième axe vertical 12. Elle est comprise entre une valeur minimale (- 18 dBFS), et une valeur maximale (0 dBFS), où dBFS est le sigle anglo-saxon de "decibels relative to Full Scale", c'est-à-dire une amplitude relative à l'échelle de quantification. Le circuit de correction automatique de gain permet d'amplifier le signal reçu par la chaîne RF de manière à utiliser au maximum l'échelle de quantification du CAN. En l'occurrence, la consigne du circuit de correction automatique de gain est généralement fixée à une valeur moyenne de l'échelle de quantification du CAN. Cependant, une consigne moyenne est inadaptée en présence de signaux de brouillage.

La figure 2 illustre le principe à la base du circuit de correction automatique de gain selon l'invention. De manière analogue à la figure 1, la figure 2 représente, par deux axes, un exemple d'amplification du signal reçu par une chaîne RF. Le premier axe 21 est identique au premier axe 11 de la figure 1. Il représente la plage de puissance du signal reçu par la chaîne RF, en dBm. Le deuxième axe 22 représente l'échelle de quantification du CAN, en dBFS. Contrairement à un circuit de correction automatique de gain conventionnel, le circuit selon l'invention fixe la valeur de consigne en fonction du gain de correction calculé. Indirectement, la valeur de consigne est fixée en fonction de l'amplitude moyenne du signal reçu par la chaîne RF. La consigne est fixée entre une première valeur, appelée consigne basse C1, et une deuxième valeur, appelée consigne haute C2. La consigne basse C1 est la consigne à appliquer pour une puissance moyenne du signal reçu inférieure ou égale à une première puissance. Elle implique un gain RF1 fonction de la puissance du signal reçu. La consigne haute C2 est la consigne à appliquer pour une puissance moyenne du signal reçu supérieure ou égale à une deuxième puissance. Elle implique un gain RF2 fonction de la puissance du signal reçu. Entre la première et la deuxième puissance, la consigne varie sensiblement linéairement. La variation de la consigne permet de réguler le signal en bas de l'échelle de quantification lorsqu'il correspond à du bruit thermique ou au signal d'un brouilleur pulsé court, et de transiter de manière continue vers une régulation proche du haut de l'échelle de quantification lorsque le signal provient d'un brouilleur continu.

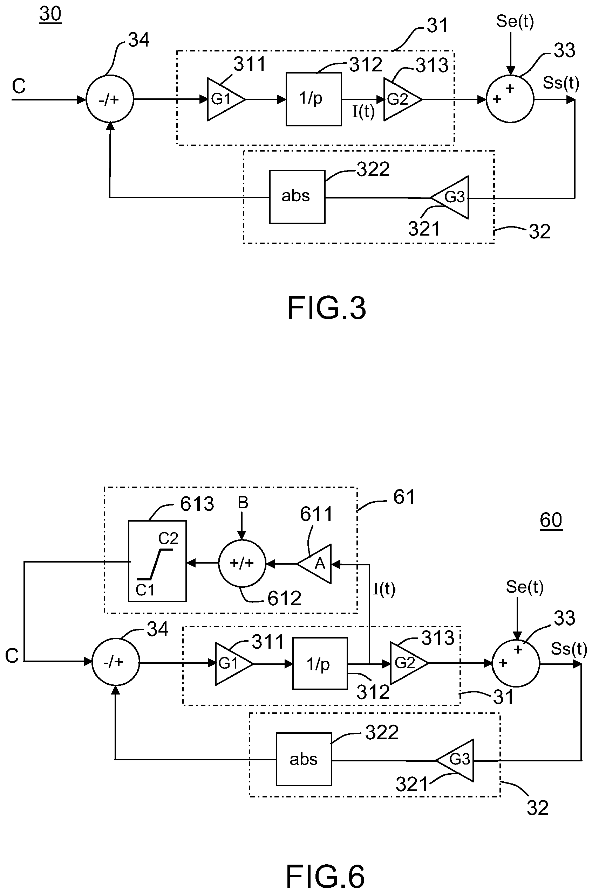

La figure 3 représente un exemple de circuit de correction automatique de gain (CAG) selon l'état de la technique. Le circuit CAG 30 forme un système bouclé. Il comprend une boucle ouverte 31, une boucle de retour 32, un additionneur 33 et un soustracteur 34. L'additionneur 33 reçoit sur une première entrée le signal à amplifier Se(t), et sur une deuxième entrée le signal en sortie de la boucle ouverte 31. Une sortie de l'additionneur 33 délivre un signal Ss(t) égal à la somme du signal Se(t) et du signal en sortie de la boucle ouverte 31. Le signal Ss(t) est injecté en entrée de la boucle de retour 32. Il est également destiné à être injecté en entrée du CAN. Le soustracteur 34 reçoit sur une première entrée le signal en sortie de la boucle de retour 32, et sur une deuxième entrée une consigne C. Une sortie du soustracteur 34 délivre un signal égal à la différence entre les deux signaux reçus en entrée. Ce signal est injecté en entrée de la boucle ouverte 31. La boucle ouverte 31 comporte, montés en série, un premier amplificateur 311 de gain G1, un intégrateur 312 et un deuxième amplificateur 313 de gain G2. La boucle de retour 32 comporte, montés en série, un troisième amplificateur 321 de gain G3 et un redresseur 322. L'agencement relatif de l'amplificateur 321 et du redresseur 322 n'a pas d'importance dans le cadre de l'invention. L'amplificateur 311 permet de régler la vitesse de réponse de l'asservissement. L'amplificateur 313 n'est pas indispensable à la réalisation de l'invention. Il permet, avec l'amplificateur 311 et l'amplificateur 321, d'obtenir un gain global G égal au produit des gains G1 et G2, divisé par le gain G3. L'amplificateur 321 représente un facteur d'échelle permettant de passer d'une unité physique à une autre. A titre d'exemple, les signaux Se(t) et Ss(t) peuvent être des signaux analogiques, et l'asservissement peut être réalisé numériquement. L'amplificateur 313 peut alors être un convertisseur numérique - analogique et l'amplificateur 321 un convertisseur analogique - numérique. Le redresseur 322 permet d'extraire la valeur absolue du signal circulant dans la boucle de retour 32 et de le comparer à la consigne C. Globalement, le circuit CAG 30 permet de réguler l'amplitude du signal Ss(t) en fonction de la consigne C.

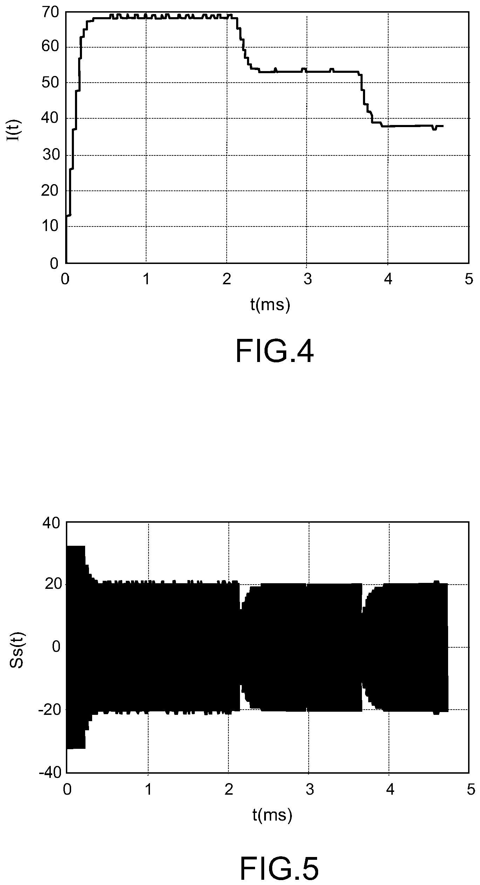

Les figures 4 et 5 illustrent le fonctionnement du circuit CAG 30 de la figure 3. La figure 4 représente, par un graphique, l'amplitude du signal I(t) en sortie de l'intégrateur 312. L'axe des abscisses du graphique représente le temps, en millisecondes. L'axe des ordonnées représente l'amplitude du signal I(t) en amplitude numérique, dans cet exemple sur 6 bits. L'amplitude du signal I(t) est représentée pour un signal Se(t) dont la puissance est constante par paliers. La figure 5 représente, par un graphique, l'amplitude du signal Ss(t) correspondant en amplitude numérique sur 6 bits. Le circuit CAG permet, comme attendu, de réguler l'amplitude du signal Sst(t) autour d'une consigne, ici égale à 20, indépendamment de la puissance du signal Se(t).

La figure 6 représente un exemple de circuit CAG selon l'invention. Le circuit CAG 60 selon l'invention se distingue du circuit CAG 30 selon l'état de la technique en ce qu'il comporte une boucle de régulation 61 de la consigne C. La boucle de régulation 61 reçoit en entrée le signal I(t) issu de l'intégrateur 312. Elle pourrait néanmoins recevoir le signal de tout point de la boucle ouverte 31. Le signal en sortie de la boucle de régulation 61 forme la consigne C. La boucle de régulation 61 comprend par exemple, montés en série, un amplificateur 611 de gain A, un additionneur 612 et un circuit fonctionnel 613. Le signal I(t) est amplifié par l'amplificateur 611 et additionné à une constante B. Le circuit fonctionnel 613 compare la valeur du signal en sortie de l'additionneur 612 avec deux valeurs, à savoir la valeur de consigne basse C1 et la valeur de consigne haute C2. Lorsque la valeur du signal en sortie de l'additionneur 612 est inférieure à la consigne basse C1, le circuit fonctionnel 613 fixe la consigne C à la consigne basse C1. Lorsque la valeur du signal est supérieure à la consigne haute C2, le circuit fonctionnel 613 fixe la consigne C à la consigne haute C2. Lorsque la valeur du signal est comprise entre ces deux consignes C1 et C2, cette valeur est utilisée comme consigne C. En d'autres termes, la boucle de régulation 61 forme un module de génération d'une consigne C recevant en entrée le signal I(t) ou, plus généralement, tout signal dont l'amplitude est proportionnelle à l'amplitude du signal d'entrée Se(t), et délivrant en sortie la consigne C dont l'amplitude est déterminée en fonction de l'amplitude du signal d'entrée Se(t). La consigne C générée par la boucle de régulation 61 est comprise entre la consigne basse C1 et la consigne haute C2.

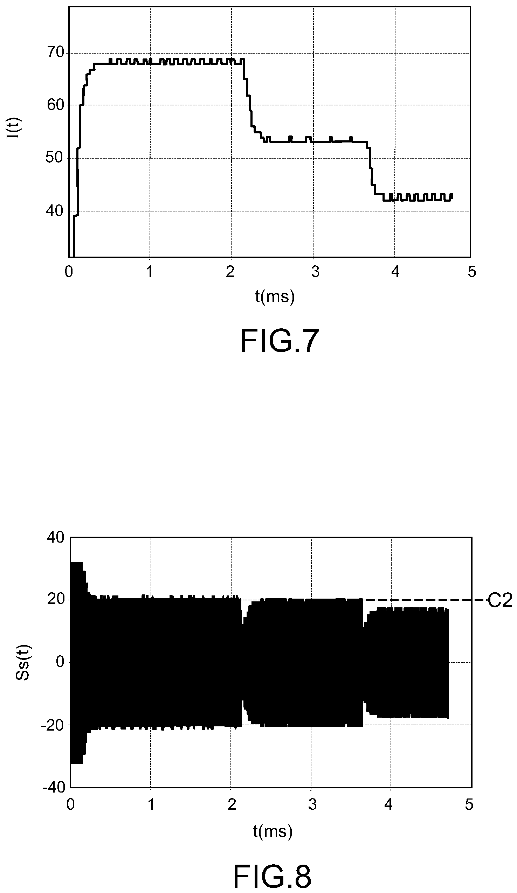

Les figures 7 et 8 illustrent le fonctionnement du circuit CAG 60 de la figure 6. La figure 7 représente, par un graphique analogue à celui de la figure 4, l'amplitude du signal I(t) en sortie de l'intégrateur 312. L'axe des abscisses représente le temps, en millisecondes. L'axe des ordonnées représente l'amplitude du signal. L'amplitude du signal I(t) est représentée pour le même signal Se(t) que celui des figures 3 et 4, dont la puissance est constante par paliers. La figure 8 représente, par un graphique analogue à celui de la figure 5, l'amplitude du signal Ss(t) correspondant. Pendant les deux premiers paliers, l'amplitude du signal en entrée du circuit fonctionnel 613 est supérieure à la consigne haute C2. En conséquence, l'amplitude du signal Ss(t) est régulée autour de la consigne haute C2. En revanche, pendant le troisième palier, l'amplitude du signal en entrée du circuit fonctionnel 613 est inférieure à la consigne haute C2. L'amplitude du signal Ss(t) est alors régulée autour d'une consigne C, inférieure à la consigne haute C2. L'amplitude du signal Ss(t) est donc dépendante de la puissance du signal à amplifier Se(t).

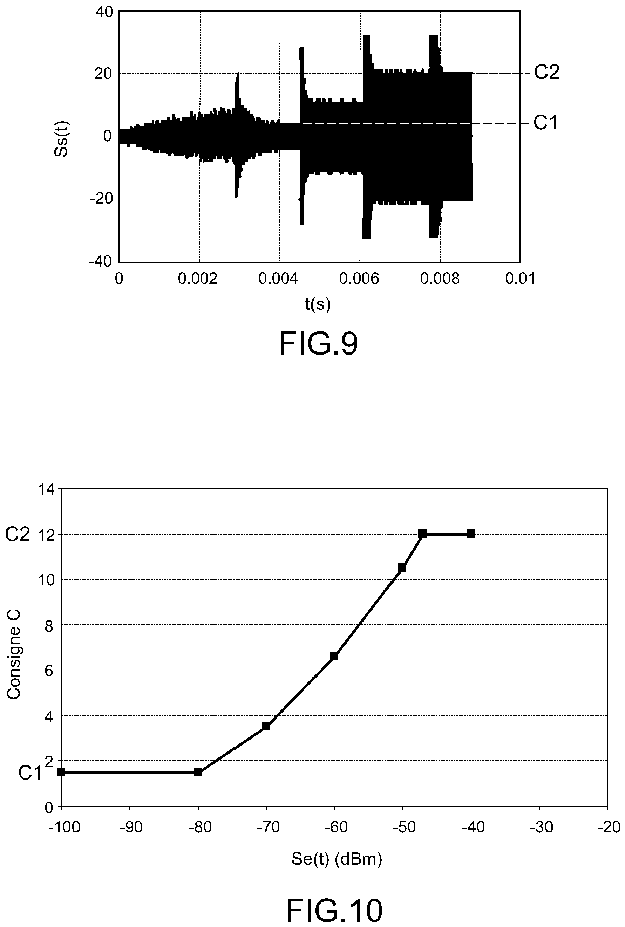

Les valeurs de A et B peuvent être déterminées de manière à ce que les consignes basse C1 et haute C2 correspondent à des puissances du signal Se(t) prédéterminées. A titre d'exemple, les valeurs de A et B sont déterminées pour que les consignes C1 et C2 correspondent respectivement à des puissances du signal Se(t) de - 80 dBm et - 40 dBm. La figure 9 représente, par un graphique analogue à celui des figures 5 et 8, l'amplitude du signal Ss(t) pour un signal Se(t) dont la puissance est constante par paliers. La puissance des paliers est successivement égale à - 100 dBm, - 80 dBm, - 60 dBm, - 40 dBm et - 20 dBm. Pour les deux premiers paliers, l'amplitude du signal Ss(t) est régulée autour de la consigne basse C1, correspondant sensiblement à une amplitude numérique de 6. Pour les deux derniers paliers, l'amplitude du signal Ss(t) est régulée autour de la consigne haute C2, correspondant sensiblement à une amplitude numérique de 20. Pour le palier à - 60 dBm, l'amplitude du signal Ss(t) est régulée à une consigne intermédiaire entre les consignes C1 et C2.

Plus précisément, les valeurs du gain A de l'amplificateur 611 et de la constante B additionnée au signal peuvent être déterminées par les étapes suivantes. Dans une première étape, les consignes C1 et C2 sont déterminées en fonction de l'échelle de quantification du CAN. La consigne C1 peut être déterminée de manière à ce que l'amplitude du signal Ss(t) soit égale à la valeur minimale pouvant être quantifiée, par exemple - 20 dBFS. La consigne C2 peut être déterminée de manière à ce que l'amplitude du signal Ss(t) soit égale à la valeur maximale pouvant être quantifiée, c'est-à-dire 0 dBFS. Dans une deuxième étape, une variation du gain G du circuit CAG 60 en fonction de la puissance du signal Se(t) est déterminée pour une consigne C donnée. Le gain G du circuit CAG 60 est défini comme étant le rapport de la puissance du signal Ss(t) sur la puissance du signal Se(t). A titre d'exemple, la consigne C donnée est la consigne haute C2. Dans une troisième étape, une valeur minimale I1 d'amplitude du signal I(t) en dessous de laquelle le signal Ss(t) doit être régulé à la consigne basse C1 et une valeur maximale I2 d'amplitude du signal I(t) au-dessus de laquelle le signal Ss(t) doit être régulé à la consigne haute C2 sont déterminées. Ces valeurs minimales I1 et maximales I2 d'amplitude du signal I(t) dépendent directement du gain G et de la puissance du signal Se(t). La troisième étape peut donc consister à déterminer un gain minimal et un gain maximal, ou une puissance minimale du signal Se(t) et une puissance maximale du signal Se(t). Par exemple, la puissance minimale du signal Se(t) en dessous de laquelle le signal Ss(t) est régulé à la consigne C1 (- 20 dBFS) est - 80 dBm, et la puissance maximale du signal Se(t) au-dessus de laquelle le signal Ss(t) est régulé à la consigne C2 (0 dBFS) est - 50 dBm. La consigne C suit alors sensiblement la loi C = A.I(t) + B sur la plage de puissance de Se(t) comprise entre - 80 dBm et - 50 dBm. Dans une quatrième étape, les valeurs de A et de B sont déterminées à partir du couple de points (I1, C1) et (I2, C2) par la résolution d'un système de deux équations à deux inconnues :

$$\begin{cases} C1 = A.I1 + B \\ C2 = A.I2 + B \end{cases}$$

La figure 10 représente, par un graphique, un exemple de relation entre la puissance du signal Se(t) à amplifier et la consigne C déterminée par la boucle de régulation 61. Dans cet exemple, les consignes C1 et C2 sont respectivement égales à 1,5 et 12. Les puissances minimales et maximales correspondantes du signal Se(t) sont respectivement égales à - 80 dBm et - 47 dBm. Sur cette figure, il est à noter que la loi de variation de la consigne C ne suit pas exactement une droite entre les puissances minimales et maximales. Cela est dû au rebouclage de la consigne, le signal I(t) étant dépendant de la consigne C, et inversement.

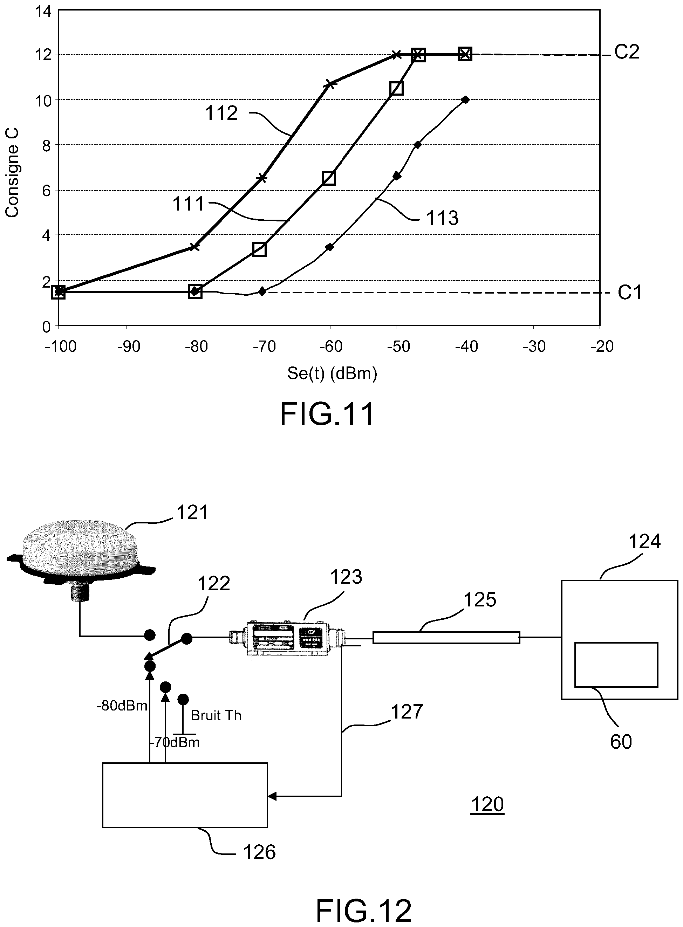

Le circuit CAG 60 selon l'invention permet d'une part d'adapter le niveau de la consigne de régulation en fonction de l'amplitude du signal à amplifier Se(t) et, d'autre part, d'asservir l'amplitude du signal amplifié Ss(t) à la consigne de régulation. Cependant, un problème peut se poser lors de l'implémentation du circuit CAG 60 dans un circuit de réception dont le gain global n'est pas connu. Ce problème se pose notamment lorsque l'antenne et le préamplificateur du circuit de réception proviennent d'un fabricant tiers, ou lorsqu'ils sont échangés. Dans de tels cas, les valeurs du gain A et de la constante B déterminées pour une courbe de gain donnée ne sont plus adaptées. La figure 11 représente, par un graphique, des exemples de relations entre la puissance du signal à amplifier Se(t) et la consigne C pour trois préamplificateurs de gains différents. Une première courbe 111 représente cette relation pour un premier préamplificateur, avec lequel les valeurs du gain A et de la constante B ont été déterminées. La première courbe 11 est donc identique à la courbe de la figure 10. Une deuxième courbe 112 et une troisième courbe 113 représentent les relations entre la puissance du signal Se(t) et la consigne C, respectivement, pour un deuxième préamplificateur, dont le gain est supérieur de 10 dB au gain du premier amplificateur, et pour un troisième préamplificateur, dont le gain est inférieur de 10 dB au gain du premier préamplificateur. La deuxième courbe 112 montre que la consigne augmente trop rapidement avec l'augmentation de la puissance du signal Se(t). Le gain de la chaîne radiofréquence étant trop élevé, les interférences pulsées ne sont plus codées avec toute la dynamique du convertisseur analogique - numérique et ne peuvent alors plus être traitées linéairement par les techniques numériques de suppression d'interférences. A l'inverse, la troisième courbe 113 montre que la consigne augmente trop tardivement avec l'augmentation de la puissance du signal Se(t). Le gain de la chaîne radiofréquence étant trop faible, les interférences continues fortes ne sont pas codées à la pleine échelle du convertisseur analogique - numérique. Les performances des traitements numériques en aval sont donc dégradées. En résumé, la connaissance du gain global du circuit de réception est souhaitable pour la détermination des valeurs du gain A et de la constante B.

La figure 12 représente un exemple de circuit de réception dans lequel est implanté un circuit CAG selon l'invention. Le circuit de réception 120 comprend une antenne 121, un commutateur 122, un préamplificateur 123, une chaîne radiofréquence 124 de traitement des signaux satellites, un câble de liaison 125 reliant la sortie du préamplificateur 123 à l'entrée de la chaîne radiofréquence 124, et un générateur 126 de signaux de puissance. Le générateur 126 permet de délivrer des signaux dont la puissance est calibrée. Il doit à tout le moins pouvoir délivrer des signaux de deux puissances de référence connues. On considère à titre d'exemple les puissances - 80 dBm et - 70 dBm. La sélection des puissances de référence à appliquer est par exemple réalisée par l'intermédiaire de signaux de contrôle passant dans le câble de liaison 125 et une liaison 127 vers le générateur 126. Le commutateur 122 permet de mettre en contact l'entrée du préamplificateur 123 avec l'antenne 121, avec une sortie du générateur 126 ou avec une masse électrique du circuit 120. Le préamplificateur 123 peut ainsi recevoir un signal dont la puissance est égale soit à - 80 dBm, soit à - 70 dBm, soit à la puissance du bruit thermique. La chaîne radiofréquence 124 comprend notamment le circuit CAG 60 selon l'invention. Le gain global du circuit de réception peut être déterminé, par exemple à chaque mise sous tension, par les étapes suivantes. Dans une première étape, la consigne du circuit CAG 60 est fixée à une valeur proche de la consigne basse C1, par exemple 1,5. Dans une deuxième étape, la puissance du signal I(t) est déterminée pour une première position du commutateur 122, dans laquelle le préamplificateur 123 reçoit un signal de puissance - 80 dBm. Cette puissance est notée $I_{80}$. Dans une troisième étape, la puissance du signal I(t) est déterminée pour une deuxième position du commutateur 122, dans laquelle le préamplificateur 123 reçoit un signal de puissance - 70 dBm. Cette puissance est notée $I_{70}$. Par interpolation linéaire, la puissance du signal I(t) peut être déterminée pour toute puissance du signal Se(t). La connaissance de la puissance du signal I(t) permet de calculer le gain entre ce signal I(t) et le signal en sortie de l'antenne 121. Ce gain permet ainsi de calculer les valeurs minimale I1 et maximale I2 d'amplitude du signal I(t) pour des puissances prédéterminées du signal Se(t), correspondant aux consignes C1 et C2. En outre, le gain constitue un indicateur de brouillage. Les valeurs de A et de B peuvent alors être déterminées à partir du couple de points (I1, C1) et (I2, C2), comme indiqué précédemment.

Par ailleurs, il est possible de déterminer l'amplitude $I_{Th}$ du signal I(t) obtenue lorsque le préamplificateur 123 est connecté à la masse électrique du circuit 120, c'est-à-dire pour un signal dont la puissance est celle du bruit thermique. Les amplitudes $I_{Th}$, $I_{80}$ et $I_{70}$ permettent de déterminer un indicateur J/N de niveau d'interférence défini par la relation suivante :

$$ J/N = 10\frac{I(t) - I_{Th}}{I_{70} - I_{80}}. $$

Cet indicateur J/N peut notamment être utilisé par la chaîne radiofréquence 124 dans les algorithmes de suppression des interférences.

**Revendications**

1. Circuit de correction automatique de gain (60) apte à recevoir un signal radiofréquence d'entrée (Se(t)) et à délivrer un signal radiofréquence de sortie (Ss(t)), dont une amplitude moyenne est asservie sur une consigne (C), **caractérisé en ce qu'**il comprend une chaîne directe (31), une chaîne de retour (32), un premier additionneur (33), un soustracteur (34) et une chaîne de régulation (61) configurée pour délivrer la consigne (C) à partir d'un signal (I(t)) de la chaîne directe (31), le premier additionneur (33) étant configuré pour additionner le signal d'entrée (Se(t)) et un signal de sortie de la chaîne directe (31) de sorte à délivrer en sortie le signal de sortie (Ss(t)), la chaîne de retour (32) étant reliée en entrée à la sortie du premier additionneur de sorte à recevoir, ledit signal de sortie Ss(t), le soustracteur (34) étant configuré pour délivrer en sortie un autre signal égal à la différence entre le signal en sortie de la chaîne de retour (32) et la consigne (C), la chaîne directe (31) étant reliée en entrée à la sortie du soustracteur de sorte à recevoir l'autre signal,

ladite chaîne de régulation (61) comprenant un amplificateur de gain (611) configurée pour amplifier le signal (I(t)) de la chaîne directe (31) et relié à sa sortie à un deuxième additionneur (612) configuré pour additionner le signal de sortie de l'amplificateur de gain (611) et une constante B et relié à sa sortie à un circuit fonctionnel (613) configuré pour comparer la valeur du signal en sortie du deuxième additionneur (612) avec une valeur de consigne minimale (C1) et une valeur de consigne maximale (C2) supérieure à la valeur de consigne minimale (C1), la consigne C étant égale à la valeur de consigne minimale (C1), lorsque la valeur du signal en sortie du deuxième additionneur (612) est inférieure à la valeur de consigne minimale (C1), et à la valeur de consigne maximale (C2), lorsque la valeur du signal en sortie du deuxième additionneur (612) est supérieure à la consigne valeur de consigne maximale (C2), et lorsque la valeur du signal en sortie du deuxième additionneur (612) est comprise entre la valeur de consigne minimale (C1) et la valeur de consigne maximale (C2), la consigne est égale à la valeur du signal en sortie du deuxième additionneur (612).

2. Circuit de correction automatique de gain (60) selon la revendication la revendication précédente, dans lequel la chaîne directe (31) comporte un amplificateur (311) de gain G1 et un intégrateur (312) montés en série.

3. Circuit de correction automatique du gain (60) selon la revendication précédente, dans lequel le signal (I(t)) de la chaîne directe (31) est un signal de sortie de l'intégrateur (312).

4. Circuit de correction automatique de gain (60) selon l'une quelconque des revendications 2 à 3, dans lequel la chaîne directe (31) comporte, en outre, un deuxième amplificateur (313) de gain G2 monté en sortie de l'intégrateur (312).

5. Circuit de correction automatique de gain (60) selon l'une des revendications précédentes, dans lequel la chaîne de retour (32) comporte un amplificateur (321) de gain G3 et un redresseur (322) apte à extraire la valeur absolue d'un signal circulant dans la chaîne de retour (32).

**Patentansprüche**

1. Schaltung zur automatischen Gain-Korrektur (60), welche in der Lage ist, ein Funkfrequenz-Eingangssignal (Se(t)) zu empfangen und ein Funkfrequenz-Ausgangssignal (Ss(t)) abzugeben, dessen mittlere Amplitude durch einen Sollwert (C) geregelt ist, **dadurch gekennzeichnet, dass** sie einen Vorwärtspfad (31), einen Rückkopplungspfad (32), einen ersten Summierer (33), einen Subtrahierer (34) und einen Regelpfad (61) beinhaltet, konfiguriert, um den Sollwert (C) anhand eines Signals (I(t)) des Vorwärtspfads (31) abzugeben, wobei der erste Summierer (33) konfiguriert ist, um das Eingangssignal (Se(t)) und ein Ausgangssignal des Vorwärtspfads (31) so zu summieren, dass am Ausgang das Ausgangssignal (Ss(t)) abgegeben wird, wobei der Rückkopplungspfad (32) im Eingang mit dem Ausgang des ersten Summierers verbunden ist, um das Ausgangssignal Ss(t) zu empfangen, wobei der Subtrahierer (34) konfiguriert ist, um am Ausgang ein anderes Signal abzugeben, welches der Differenz zwischen dem Signal am Ausgang des Rückkopplungspfads (32) und dem Sollwert (C) entspricht, wobei der Vorwärtspfad (31) im Eingang mit dem Ausgang des Subtrahierers verbunden ist, um das andere Signal zu empfangen,
wobei der Regelpfad (61) einen Gain-Verstärker (611) besitzt, konfiguriert, um das Signal (I(t)) des Vorwärtspfads (31) zu verstärken und verbunden an seinem Ausgang mit einem zweiten Summierer (612), konfiguriert zum Summieren des Ausgangssignals des Gain-Verstärkers (611) und einer Konstante B und verbunden an seinem Ausgang mit einer Funktionsschaltung (613), konfiguriert zum Vergleichen des Wertes des Signals am Ausgang des zweiten Summierers (612) mit einem Mindestsollwert (C1) und einem Höchstsollwert (C2), welcher höher als der Mindestsollwert (C1) ist, wobei der Sollwert C gleich dem Wert des Mindestsollwertes (C1) ist, wenn der Wert des Signals am Ausgang des zweiten Summierers (612) kleiner ist als der Mindestsollwert (C1), und gleich dem Höchstsollwert (C2) ist, wenn der Wert des Signals am Ausgang des zweiten Summierers (612) höher ist als der Höchstsollwert (C2), und wenn der Wert des Signals am Ausgang des zweiten Summierers (612) zwischen dem Mindestsollwert (C1) und dem Höchstsollwert (C2) liegt, der Sollwert gleich dem Wert des Signals am Ausgang des zweiten Summierers (612) ist.

2. Schaltung zur automatischen Gain-Korrektur (60) nach dem vorhergehenden Anspruch, bei welcher der Vorwärtspfad (31) einen Gain-Verstärker (311) G1 und einen Integrator (312) beinhaltet, welche in Reihe geschaltet sind.

3. Schaltung zur automatischen Gain-Korrektur (60) nach dem vorhergehenden Anspruch, bei welcher das Signal (I(t)) des Vorwärtspfads (31) ein Ausgangssignal des Integrators (312) ist.

4. Schaltung zur automatischen Gain-Korrektur (60) nach einem der Ansprüche 2 bis 3, bei welcher der Vorwärtspfad (31) zudem einen zweiten Gain-Verstärker (313) G2 beinhaltet, welcher am Ausgang des Integrators (312) montiert ist.

5. Schaltung zur automatischen Gain-Korrektur (60) nach einem der vorhergehenden Ansprüche, bei welcher der Rückkopplungspfad (32) einen Gain-Verstärker (321) G3 und einen Gleichrichter (322) beinhaltet, welcher in der Lage ist, den Absolutwert eines in dem Rückkopplungspfad (32) zirkulierenden Signals zu extrahieren.

**Claims**

1. An automatic gain correction circuit (60) capable of receiving an input radiofrequency signal (Se(t)) and of delivering an output radiofrequency signal (Ss(t)), a mean amplitude of which is slaved to a setpoint (C), **characterised in that** it comprises a forward path (31), a feedback path (32), a first adder (33), a subtracter (34), and a regulating path (61) configured to deliver the setpoint (C) on the basis of a signal (I(t)) from the forward path (31), the first adder (33) being configured to add the input signal (Se(t)) and an output signal from the forward path (31) so as to deliver the output signal (Ss(t)) as output, the feedback path (32) being connected as input to the output of the first adder so as to receive said output signal (Ss(t)), the subtracter (34) being configured to deliver as output another signal equal to the difference between the signal output from the feedback path (32) and the setpoint (C), the forward path (31) being connected as input to the output of the subtracter so as to receive the other signal,
said regulating path (61) comprising a gain amplifier (611) configured to amplify the signal (I(t)) from the forward path (31) and connected at its output to a second adder (612) configured to add the output signal of the gain amplifier (611) and a constant B and connected at its output to a functional circuit (613) configured to compare the value of the signal output from the second adder (612) to a minimum setpoint value (C1) and a maximum setpoint value (C2) greater than the minimum setpoint value (C1), the setpoint C being equal to the minimum setpoint value (C1) when the value of the signal output from the second adder (612) is lower than the minimum setpoint value (C1) and being equal to the maximum setpoint value (C2) when the value of the signal output from the second adder (612) is greater than the maximum setpoint value (C2), and being equal to the value of the signal output from the second adder (612) when the value of the signal output from the second adder (612) is between the minimum setpoint value (C1) and the maximum setpoint value (C2).

2.  The automatic gain correction circuit (60) as claimed in the preceding claim, wherein the forward path (31) comprises an amplifier (311) of gain G1 and an integrator (312) mounted in series.

3.  The automatic gain correction circuit (60) as claimed in the preceding claim, wherein the signal (I(t)) of the forward path (31) is an output signal of the integrator (312).

4.  The automatic gain correction circuit (60) as claimed in any one of claims 2 to 3, wherein the forward path (31) further comprises a second amplifier (313) of gain G2 mounted at the output of the integrator (312).

5.  The automatic gain correction circuit (60) as claimed in any one of the preceding claims, wherein the feedback path (32) comprises an amplifier (321) of gain G3 and a rectifier (322) capable of extracting the absolute value of a signal circulating in the feedback path (32).

Puissance
reçue                    11

-X dBm — Brouilleur
         Max

Puissance
d'entrée
CAN                      12

0 dBFS —

Gain RF          ⟹        C

-18 dBFS —

-100 dBm — Niveau
           de bruit

FIG.1

Puissance
reçue                    21

-X dBm — Brouilleur
         Max

Puissance
d'entrée
CAN                      22

0 dBFS —

Gain RF 2    ⟹    C2

Gain RF 1    ⟹    C1
              -72 dBFS —

-100 dBm — Niveau
           de bruit

FIG.2

FIG.3

FIG.6

FIG.4

FIG.5

FIG.7

FIG.8

FIG.9

FIG.10

FIG.11

FIG.12

**EP 2 707 952 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2004092238 A1